# EUROPEAN PATENT SPECIFICATION

(11) **EP 3 965 139 B1**
(45) Date of publication and mention of the grant of the patent: **27.03.2024**
(21) Application number: 20194423.8
(22) Date of filing: 03.09.2020
(51) Int. Cl.: H01J 37/32

(54) **APPARATUS, SYSTEM AND METHOD FOR SUSTAINING INDUCTIVELY COUPLED PLASMA**
VORRICHTUNG, SYSTEM UND VERFAHREN ZUR AUFRECHTERHALTUNG VON INDUKTIV GEKOPPELTEM PLASMA
APPAREIL, SYSTÈME ET PROCÉDÉ DE MAINTIEN D'UN PLASMA À COUPLAGE INDUCTIF

(43) Date of publication of application: 09.03.2022
(73) Proprietor: Jozef Stefan Institute, 1000 Ljubljana (SI)
(72) Inventor: Zaplotnik, Rok, 1000 Ljubljana (SI); Primc, Gregor, 1000 Ljubljana (SI); Vesel, Alenka, 1000 Ljubljana (SI); Mozetic, Miran, 1000 Ljubljana (SI)
(74) Representative: Jersan, Tatjana

(56) References cited:
- JP-A- 2002 217 186
- US-A1- 2012 211 166
- US-A1- 2019 074 164
- US-B1- 6 417 626

## Description

### FIELD OF THE INVENTION

The present invention relates to an apparatus for igniting and/or sustaining an inductively coupled gaseous plasma, to a method of igniting and/or sustaining such a plasma, and to a use of the apparatus.

### BACKGROUND OF THE INVENTION

Gaseous plasma can be sustained in a number of ways. One manner in which to sustain plasma in this way is by using capacitive coupling. However, capacitive coupling of plasma involves substantial waste of energy as the heating of electrons from the electric field is not equally present throughout the volume of the plasma, but rather concentrated to a sheath region. Alternatively, gaseous plasma can be inductively coupled in one of the E-mode and the H-mode. Inductive coupling in the H-mode enables heating of electrons from atoms throughout the volume of the plasma, and is thus preferred. However, sustaining plasma in the H mode is highly sensitive and requires strict conditions to be met in order to achieve strong inductive coupling and to sustain high density plasma.

Gaseous plasma can be sustained by being subjected to electric fields. Gaseous plasma comprises free plasma electrons, which collide with neutral gaseous molecules. When an electric field of sufficiently high voltage is applied to the gaseous plasma, the plasma electrons acquire enough kinetic energy to collide inelastically with neutral gaseous molecules. These inelastic collisions may 'knock' electrons out of neutral gaseous molecules, thereby ionising the gaseous molecule. This results in positively charge gaseous ions and additional free plasma electrons.

Soon after plasma ignition, a space charge is formed in the vacuum chamber. The electrons in the plasma make substantially more contact with the surface than gaseous ions. The surface thus becomes negatively charged and attracts positively charged molecules. Consequently, a sheath of positive gaseous ions is formed between the surface of the reactor and the bulk of the plasma.

The electric field within the sheath is large, whereas the electric field in the bulk plasma is small. As a consequence, the electrons do not gain substantial energy throughout the entirety of the plasma, but rather only within or near the sheaths. The absorption of energy supplied by the electric field is thus limited to the sheath. As a consequence, the plasma close to the surface of the vacuum chamber is subjected to heating, while the electrons in the bulk plasma are not heated to the same extent.

The impedance of the sheath has a capacitive character whenever a high-frequency discharge is used for sustaining gaseous plasma. The power that can be transferred into the gaseous plasma in the capacitive mode is thus limited by thermal properties of materials facing the plasma. Stray effects, including the formation of unipolar arcs, are common when large power is available in the capacitive mode.

The positive ions from the gaseous plasma are accelerated within the sheaths and bombard the electrode with a kinetic energy that corresponds to the voltage across the sheath. The bombardment of the electrode by ions is not always beneficial and should be suppressed. In such circumstances, inductively coupled plasma (referred to heron as ICP) is preferable.

ICP is achieved using a radiofrequency coil or the like. The radiofrequency coil may, for example, be a helical electric conductor coupled such as a coil or a spiral or the like, that is powered on one end by a radiofrequency generator and grounded at the other. In this way, the electric field is governed by the impedance of the coil and not by the impedance of the plasma as in the case of the capacitive coupling.

ICP can be sustained in one of two modes: an E-mode or a H-mode. In the E-mode, the largest electric field is established within the sheath between the side of the coil which is connected to the voltage supply and the nearby gaseous plasma. The impedance of the sheath is smaller than the impedance of the coil, so the total impedance of the electric circuit is governed by the sheath impedance. In the E-mode (or in capacitive coupled RF plasma), power may be dissipated as heat to surfaces in close proximity to the electrode, in other words wasted.

If the plasma density is below a critical value, a spontaneous transition from H- to E-mode is observed. This transition is abrupt, and a hysteresis is observed. The H-mode is achievable at reasonable pressure only at high power density, thus a high electromagnetic field is necessary. The electromagnetic field is highest within the volume of the coil. The H-mode is only achievable outside the coil at very high energy electric fields.

ICP in the H-mode is characterized by a high density of charged particles. ICP in the H mode is more energy efficient than ICP in the E mode. In the H mode, available power is used to heat plasma electrons. Plasma electrons transfer their kinetic energy to gaseous molecules causing excitation, dissociation and/or ionization. In the H-mode more power is supplied to the entirety of the plasma, rather than just to the sheath. ICP in the H mode is thus preferred for the purposes of sustaining a gaseous plasma according to the present invention.

The proximity of a grounded metallic object will disturb the plasma in H-mode or even prevent sustaining ICP in the H-mode. Therefore, the impedance of any element between the coil and a grounded metallic object should be much larger than the impedance of gaseous plasma sustained in the H-mode.

Therefore, in order to sustain an ICP in the H-mode, two conditions are necessary: a) a sufficiently large electromagnetic field, and b) the absence of any grounded electrically conductive element in close proximity to the radiofrequency coil (or equivalent helical electrical conductor).

The prior art teaches inductive coupling of a RF generator to a low-pressure gaseous plasma via a coil wrapped around a dielectric cylinder. A typical example is disclosed in CN1378248 (A). The coil is connected to an RF generator via a matching network. Such a configuration enables a uniform plasma to be sustained within the dielectric cylinder in the volume enclosed by the coil. A drawback of this configuration is that the coil impedance may be too large at high RF frequencies. Thus, the number of coil turns should be minimized. A solution with one single turn of a coil connected to a dielectric tube is provided, for example, in TW200518639 (A). Several configurations have been adopted, including a helicon-type antenna as disclosed in JPH07221078 (A).

These methods are applicable only for sustaining inductively coupled plasma in the H-mode in dielectric tubes of small diameter, typically up to a few 10 cm. The induced electric field in coils of small diameters is large enough to sustain gaseous plasma in the H-mode. For larger dimensions, the field provided by the RF generator is not large enough to sustain ICP in the H-mode at reasonable pressures (i.e. more than a few Pa). Innovative solutions should be therefore adopted for large plasma reactors.

One solution is the use of several inductively coupled sources connected to the outer side of the metallic wall, such as disclosed in KR20110052429 (A). Here, a plasma generating apparatus is provided to enhance the density of plasma which is generated by interlinking one or more ICP antenna to an angular division electrode and to enhance the uniformity of plasma by removing the standing wave effect.

US2004079485 discloses a system wherein the antenna has a plurality of coils having different radiuses, at least one of the coils being a serpentine coil bent in a zigzag pattern. Capacitors are connected between the RF power source and a matching network and between the matching network and the antenna, in parallel with the antenna, to induce a LC resonance phenomenon.

US6,417,626 (B1) discloses a system having one or more coils are immersed into a coil positioner made from a dielectric material. The coil and its positioner are embedded within dielectric material comprising an inner and an outer dielectric wall. The inner and outer dielectric walls separate the coil positioned in the dielectric positioner from the vacuum. Deposition shields are mounted between both the inner and outer dielectric wall and the plasma in the vacuum chamber, and the shields are interconnected by a ring-shaped annular wall. Both inner and outer deposition shields are grounded and are preferably constructed of a material of high electrical conductivity. Alternatively, they are made from a lower-conductivity material but coated with a high-conductivity material.

A somewhat different configuration is disclosed in US5,309,063. As in US6,417,626 (B1), the RF coil enables sustaining gaseous plasma outside the coil. The coil is placed into a cup-shaped window which is immersed rather deep within the vacuum chamber. The window may be of an insulating or conductive material, but preferably of an insulator coated with a thin conductive film. No plasma is sustained within the coil, since the coil is placed in air at ambient atmosphere. The configuration enables for good plasma homogeneity. In preferred embodiments the gradient of plasma density in the space between the coil within a cup-shaped window and the outer cylinder on the metallic chamber is almost negligible - a drop for a factor of 2 is reported over the distance as large as 6 inches.

A plurality of cup-shaped windows immersed rather deep into the metallic vacuum chamber is disclosed in US2008/0050292 (A1). The cup-shaped windows are protective cups made from quartz-glass, ceramics or other dialectic material. Unlike US6,417,626 (B1), no metallic coating on the cups' surface is provided. A ferromagnetic core is inserted into the RF coil to intensify the electromagnetic coupling. The ferromagnetic core has a form of a tube and is fitted onto the rod-like heat conductor made from a material that has high thermal conductivity, such as Cu, Al or high thermal conductivity ceramics. Apparently, no plasma is sustained within the coil, but the configuration enables good spatial homogeneity of plasma sustained outside the RF coil, similar to US6,417,626 (B1).

Both configurations as in US5,309,063 and US2008/0050292(A1) do not enable strong inductive coupling, which is needed for sustaining high-power plasma in the H-mode with a power density of at least 10 W/cm³. In fact, they disclose a simple one-wall dielectric cup that is not suitable for sustaining plasma in H-mode.

JP2002217186 describes a plasma processor and plasma generating source which uses a quartz dome and a wafer in a vacuum chamber, introducing plasma to the quartz dome. US2019/074164 describes a reaction chamber with upper and lower electrode devices for processing semiconductors. US2012/211166 describes ion sources and methods for generating an ion bean with a controllable ion current density distribution
There remains a need for an apparatus capable of sustaining high-power plasma in the H-mode with a high power density. This invention addresses these and other problems of the prior art.

### SUMMARY OF THE INVENTION

The invention is defined by the claims.

In a first embodiment of the invention there is provided an apparatus for ignition and/or sustenance of an inductively coupled plasma, in accordance with claim 1, comprising:
a vacuum chamber defined by a vacuum chamber wall and suitable for enclosing
a plasma, said chamber wall having an opening therein;
a plasma chamber located in the opening,
the plasma chamber comprising a generally tubular dielectric side wall, a dielectric outer wall substantially coaxial with the side wall, and at least an open end, the side wall and outer wall being continuous, such that the side wall and outer wall define a toroidal trough in the vacuum chamber, the open end allowing fluid communication between the plasma chamber and the vacuum chamber,
the plasma chamber being substantially within the vacuum chamber wall; and
a radiofrequency coil disposed around the periphery of the side wall within the toroidal trough;
wherein a peripheral portion of the toroidal trough comprising at least part of the side wall and outer wall is unshielded from the plasma.

The opening may be an annular opening.

The plasma chamber may form a hermetic seal with the vacuum chamber wall. Preferable features of this embodiment are given in claims 2 to 8.

In a second embodiment of the invention there is provided the use of an apparatus of the invention for generating and/or sustaining inductively coupled gaseous plasma in the H-mode, in accordance with claim 9.

In a third embodiment of the invention there is provided method of treating the surface of a material comprising exposing the material to a plasma generated in an apparatus of the invention, in accordance with claim 10.

In a fourth embodiment of the invention there is provided a method of igniting and/or sustaining an inductively coupled plasma, in accordance with claim 13.

### BRIEF DESCRIPTION OF THE DRAWINGS

Fig. 1 shows schematically an arrangement for sustaining gaseous plasma in a vacuum chamber, which may be useful for understanding the invention;
Fig. 2 shows schematically an apparatus for sustaining gaseous in a first embodiment of the invention;
Fig. 3 shows graphically the intensity of radiation arising from gaseous plasma in the arrangement of Fig. 1 and in the apparatus of Fig. 2, at a pressure of 10 Pa;
Fig. 4 shows graphically the intensity of radiation arising from gaseous plasma in the arrangement of Fig. 1 and in the apparatus of Fig. 2, at a pressure of 100 Pa;
Fig. 5 shows schematically an apparatus for sustaining gaseous plasma in the H-mode in a second embodiment of the invention;
Fig. 6 shows graphically the thickness of the deposited film versus treatment time using plasma sustained in the arrangement of Fig. 1 and plasma sustained in an embodiment of the present invention; and
Fig. 7 shows schematically the apparatus for sustaining gaseous plasma in a third embodiment of the invention.

### DETAILED DESCRIPTION OF THE INVENTION

The present invention relates to an apparatus, and method for igniting and/or sustaining inductively coupled plasma. The apparatus has a vacuum chamber defined by a vacuum chamber wall. As used herein, the term "vacuum" refers to a subatmospheric pressure. The vacuum chamber may be at a pressure of from 0.1 and 1000 Pa. Preferably, the pressure is between 10 Pa and 100 Pa.

A vacuum pumping system is operably connected for fluid communication through a vacuum port provided in the chamber wall. A vacuum pumping system is provided for evacuating and maintaining a vacuum or subatmospheric pressure appropriate for initiating and sustaining a plasma in vacuum processing space. Suitable vacuum pumping systems are familiar to those of ordinary skill in the art of plasma processing.

A gas inlet may coupled via a gas conduit and a flow controller to a process gas supply for supplying a process gas, such as a molecular gas (e.g. argon), to the vacuum chamber. Typically, after vacuum chamber is evacuated to a base vacuum pressure, process gas may be supplied through an inlet to establish an operating vacuum pressure in the range above. The atmosphere of process gas within vacuum chamber may be held static at the operating vacuum pressure or, alternatively, process gas may be supplied with a suitable flow rate through a gas inlet while the processing space is continuously pumped by the vacuum pumping system to maintain the operating vacuum pressure.

According to the present invention, the plasma source is provided in the vacuum chamber wall. The vacuum chamber wall is provided with an annular opening, which is matched to the size and shape of the plasma source. There is substantially no gap between the plasma source and the vacuum chamber wall so as to provide a vacuum tight or hermetic seal. The plasma source is suitably provided with an annular flange at one end to ensure this. Optionally, an O-ring, gasket or other seal may be provided between the vacuum chamber wall and the plasma source.

In some embodiments, the flange is additionally insulated with a dielectric ring placed below the annular opening and tightly mounted on the portion of the vacuum chamber wall.

The plasma source is of a double-cup construction. It comprises a generally tubular dielectric side wall defining a plasma chamber within, a dielectric outer wall substantially coaxial with the side wall, and at least an open end, the allowing fluid communication between the plasma chamber and the vacuum chamber, the side wall and outer wall being continuous, such that the side wall and outer wall define a toroidal trough.

Optionally, and preferably, the plasma source comprises an end wall, which abuts the side wall and closes the plasma chamber at one end. The end wall is preferably made of a dielectric material. In this embodiment, the outer wall, side wall and end wall are continuous. As used herein, the term "continuous" means that the walls are intimately connected without any intervening gap or structure. Optionally, they may be made from a single piece of dielectric material. Alternatively, they may be made from separate pieces bonded together.

Optionally and preferably the side wall and outer wall are connected to an annular end wall, which defines the bottom of the toroidal trough.

The side wall and end wall (if present) together define the plasma chamber, which is of generally cylindrical shape. It may be tapered toward one end and thus define a frustoconical space.

The plasma chamber is preferably substantially within the vacuum chamber.

Thus, the outer wall is in contact with the vacuum on one face only. Similarly, the side wall is in contact with the vacuum on one face only. The walls are in direct contact with the plasma, in contradistinction to the disclosure of the prior art, which teaches the necessity of providing deposition shielding of a conductive nature.

The radiofrequency coil is at least partially within the perimeter of the vacuum chamber inside the toroidal trough. At least one turn of the radiofrequency coil is within the perimeter of the vacuum chamber. Preferably, at least half of the coil is within the perimeter of the vacuum chamber. In some embodiments, the entire coil is within the perimeter of the vacuum chamber. The radiofrequency coil is not itself exposed to the vacuum; instead, it may be in air at ambient pressure, or in some other gas. The toroidal space may comprise ambient air. The toroidal space may be sealed.

The radiofrequency coil may be a helical electric conductor having a single loop, a coil or a spiral shape. The radiofrequency coil may comprise a first end suitable for being coupled to a radio frequency electric field generator, and a second end suitable for being electrically grounded.

In preferred embodiments, the coil is tightly wound around the side wall, such that the gap between the coil and the side wall is minimized. This favours generation of plasma within the coil, which is desirable, and minimizes it outside the coil. In some embodiments, there is a gap between the coil and the outer wall. The gap between the coil and the outer wall is preferably between 1 and 10 mm.

The vacuum chamber preferably comprises a metallic housing. The distance between any point of the metallic housing and an end of the radiofrequency coil, which is suitable for being coupled to a generator, is between 1 cm and 20 cm, preferably between 8 cm and 12 cm, such as about 10 cm.

The vacuum chamber may be at a pressure of from 0.1 and 1000 Pa. Preferably, the pressure is between 10 Pa and 100 Pa.

The side, outer and end walls are made of a dielectric material. The dielectric material may comprise at least one of glass and ceramic. In some embodiments, the outer wall is thicker than the inner wall. This assists in the generation of a plasma within the coil, which is a desirable goal of the invention.

The apparatus may comprise plural plasma sources disposed on a single vacuum chamber.

The radio frequency electric field generators may be arranged to supply the radiofrequency coil with an electrical field having a frequency between 10 kHz and 1000 MHz, at a power between about 50 watts and about 5000 watts, more preferably between 200 and 1000 watts, such as about 700 watts. The apparatus may be provided with a matching unit which is an electrical circuit familiar to those of ordinary skill in the art that accommodates the temporally-varying impedances of RF power supply and RF coil. Matching unit is configured to optimize the RF power applied to the coil and to optimize the RF energy transferred into the plasma under the dynamic electrical load presented by the plasma.

A substrate support is optionally provided within the vacuum chamber. Such a substrate support is configured to receive and support a substrate, such as, for example, a silicon wafer or a sheet of any material. The substrate is typically clamped or chucked to the substrate support, which is supported by, but electrically insulated from, the chamber wall. In an embodiment, the sheet material may be a gallium arsenide wafer.

The apparatus of the invention may be used in any application where plasmas are required, including sputter etching, reactive ion etching, ionized physical vapor deposition, plasma-enhanced chemical vapor deposition, surface conditioning, and surface cleaning. Preferred applications are plasma-enhanced chemical vapor deposition, surface conditioning, and surface cleaning.

For better understanding, preferred embodiments of the invention are described with particular reference to the figures.

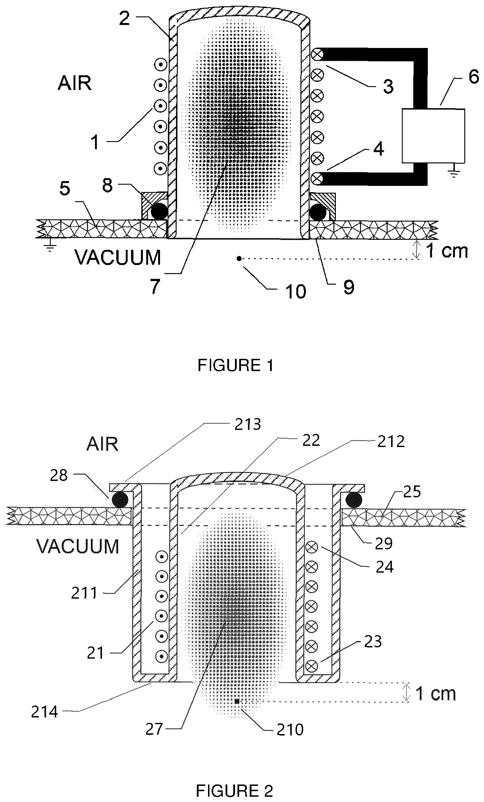

Fig. 1 shows a known arrangement for sustaining gaseous plasma in a vacuum chamber, which may be useful for understanding the invention. The arrangement comprises an RF coil 1 wrapped around a generally tubular plasma chamber 2. The RF coil comprises a first end 3 and a second end 4. The arrangement also comprises a vacuum chamber 5 having a metallic housing, and an RF generator 6 for providing an electric field. The first end 3 of the coil 1 is positioned away from the metallic housing of the vacuum chamber 5. The first end 3 of the coil 1 is connected to the high voltage side of the RF generator 6. The second end 4 of the coil 1 is positioned close to the metallic housing of the vacuum chamber 5 and is connected to the grounded side of the RF generator 6. A matching network (not shown in Figure 1) may be mounted between the coil 1 and the RF generator 6 to suppress capacitive coupling between the coil 1 and the metallic housing of the vacuum chamber 5. A typical thickness of the metallic housing of the vacuum chamber 5 may be between 0.5 cm and 5 cm. In an example, the thickness may be 1cm. The generally tubular plasma chamber 2 may be sealed to the metallic housing of the vacuum chamber 5 using a gasket 8.

Since the requirements for inductive coupling between the electromagnetic field provided by the RF generator 6 and plasma electrons are met only within the volume inside the coil 1, dense plasma 7 concentrates in the volume within the coil 1. In theory, if the metallic housing of the vacuum chamber 5 is thin, the dense plasma 7 may be able to stretch into the vacuum chamber 5. In practice, however, the housing is thick so as to be able to withstand mechanical forces between the vacuum inside the metallic housing and ambient air.

Inductive coupling of RF generator to low-pressure gaseous plasma may be via a coil wrapped around a dielectric cylinder. A drawback of this configuration is that the coil impedance may be too large at high RF frequencies. This is only applicable for sustaining inductively coupled plasma in the H-mode in dielectric tubes of small diameter, typically between 1 cm to 30 cm. The induced electric field in coils of small diameters is large enough to sustain the gaseous plasma in the H-mode. For larger dimensions, the field provided by the RF generator is not large enough to sustain ICP in the H-mode at reasonable pressures, of, say, more than a 10 Pa.

A further drawback of the inductive coupling in the arrangement of Fig. 1 is the fact that a high electromagnetic field is limited to the area within and immediately around the coil. Elsewhere in the plasma chamber, the gaseous plasma contains far fewer electrons and is similar to that sustained using the capacitive mode. In other words, the vacuum chamber may comprise areas of diffusing plasma having low electron density. The boundary between the dense plasma sustained in the H-mode and the diffusing plasma is rather sharp, in particular at elevated pressures of about 100 Pa.

Fig. 2 shows in sectional view an apparatus for sustaining gaseous plasma in a first embodiment of the invention. The apparatus includes a vacuum chamber, having a wall 25 having an aperture of generally annular shape, within which sits the plasma source. The plasma source includes a circumferential flange 213 of larger diameter than the aperture. The flange 213 sits on top of gasket 28 which forms a seal between the flange 213 and wall 25. Projecting from flange 213 is the tubular outer wall 211, which passes through the aperture and for the most part projects into the vacuum chamber. Substantially coaxial with outer wall 211 is the tubular inner wall 22. The inner 22 and outer 211 walls are connected at the lower edges by annular bottom wall 214, such that inner 22 and outer 211 walls form a double-walled cylinder. Inner wall 22 is closed at the top end by slightly domed end wall 212.

Although not shown in Figure 2, in some embodiments the metallic flange 213 is additionally insulated with a dielectric ring placed below the annular opening and tightly mounted on the portion of the metallic vacuum chamber housing 29.

Disposed between inner 22 and outer 211 walls is a toroidal trough 21, which sits mainly below the level of the vacuum chamber wall 25. The inner wall 22 defines a cylindrical plasma chamber 27, which sits within the vacuum chamber, and is in fluid communication with the vacuum.

The RF coil 23, 24 is disposed in the toroidal trough 21, within the vacuum chamber wall 25. At least one of the plasma chamber 27 and the outer wall 211 comprises a dielectric material able to withstand high temperatures. The dielectric material may comprise glass and/or ceramic.

In an example, at least one of the inner wall 22 and the outer wall 211 is a dielectric tube. The dielectric tubes may be cylindrical (of circular cross-section) as the mechanical strength of cylindrical tubes is superior to tubes of other geometries, for example of rectangular cross-section. In an example, the dielectric tubes may be tilted. The tube may be sealed. Additionally, or alternatively, an inner side of the dielectric tube radially shifted. The plasma chamber and the outer wall form an annular shape.

In this way the coil 23, 24 may be provided in air or other gas, whilst also being located within the perimeter of the vacuum chamber wall 25. A larger proportion of the electric field immediately around the coil in the arrangement shown in Fig. 2 is thus exposed to plasma within the plasma chamber 27, thereby allowing a greater proportion of plasma electrons to be heated and thus sustain the plasma in the H-mode.

Plasma chamber 27 within the RF coil 23, 24 is under vacuum in order to sustain a dense plasma (not shown). A first end 23 of the coil is connected to the RF generator (not shown). A second end 24 of the coil is grounded. The RF generator (not shown) may operate at frequency range of 1 MHz to 300GHZ. Preferably the RF generator may operate at a frequency range of 10 kHz to 1000MHz. In an example, the RF generator 6 may operate at a standard industrial frequency of 13.56 MHz.

The distance between the first end 23 of the RF coil and a portion of the metallic housing 29 in close proximity to the plasma chamber 27 is sufficiently large to suppress any significant capacitive coupling effect between dense plasma within chamber 27 and the portion of the metallic housing 29. In this way the present invention allows plasma to be sustained in the H-mode. The distance may be between 1 cm and 20 cm. At such a distance, any capacitive coupling between the coil 23, 24 and the metallic housing 29 is suppressed. The plasma within the plasma chamber 27 can be therefore sustained in almost pure H-mode.

This arrangement enables the RF coil to be greatly exposed to the vacuum chamber, thereby allowing strong inductive coupling to occur in the H-mode. In this way, plasma of a power density up at least 10 W/cm³ can be sustained using the apparatus of the invention.

The RF coil may be partially exposed to the vacuum chamber. In an example one turn of the RF coil is exposed to the vacuum. In another example, the RF coil is substantially exposed to the vacuum chamber.

The pressure difference between the toroidal trough 21 and the outer wall 211 may be at least 1 bar. This internal pressure is sufficiently high to prevent discharging between the plasma chamber side wall 22 and the outer wall 211 when the apparatus is in use.

Advantages and benefits of the example embodiment of the apparatus of Fig. 2 over the arrangement of Fig.1 can be seen, for example, by measuring the intensity of optical emission from the plasma sustained in both arrangements.

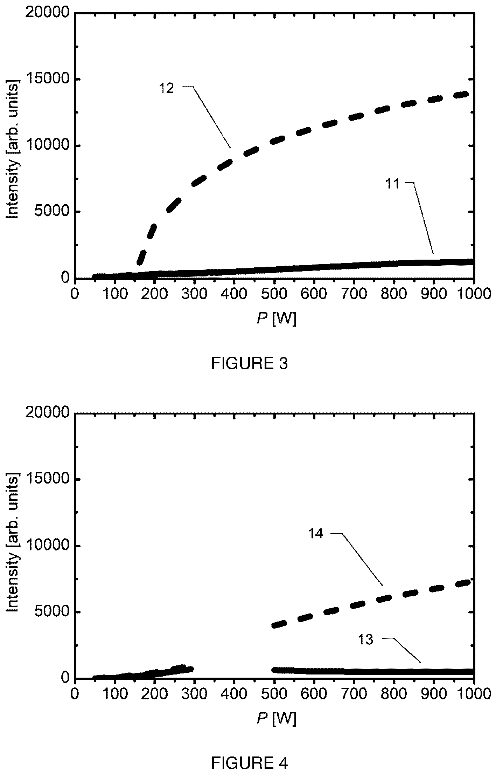

Fig. 3 and Fig. 4 show graphically the intensity of optical emission from plasma versus the discharge power adsorbed by gaseous plasma in the arrangement of Fig. 1 and in the arrangement of Fig. 2, at two different pressure values. To achieve the example measurements shown in Fig. 3 and 4, an optical spectrometer was focused at a probing position 10 shown at Fig. 1 and position 210 Fig. 2.

In this example arrangement, the RF generator 6 operates at the standard industrial frequency of 13.56 MHz. More generally, the RF generator may operate at frequency range of 1 MHz to 300MHZ.

Fig. 3 shows graphically the intensity of the radiation arising from gaseous plasma at the probing positions 10 and 210 at a pressure of 10 Pa. Curve 11 shows the intensity of radiation at the focal spot 10 in the arrangement such as that shown in Fig. 1. Curve 12 in Fig. 3 shows the intensity of radiation at the focal spot 210 in an apparatus such as that shown in Fig. 2.

At higher powers, the intensity of radiation represented by curve 12, i.e. radiation observed from plasma sustained in the apparatus of Fig. 2, is approximately an order of magnitude greater than the intensity of radiation represented by curve 11, i.e. radiation observed from plasma sustained in the arrangement of Fig.1. This is because the dense plasma in the apparatus of Fig. 2 expands at least 1 cm from the innermost part of the plasma chamber, whilst only the diffusing plasma provides the radiation in the arrangement of Fig. 1. At low powers the difference between curve 11 and curve 12 is marginal since only the diffusion plasma expands to the focal spot 10 or 210. In the conditions that rendered the results shown in Fig. 3, below approximately 150 W the plasma was in the E-mode, while above approximately 200 W the plasma was in the H-mode.

Fig. 4 shows graphically the intensity of the radiation arising from gaseous plasma at the probing positions 10 and 210 at a pressure of 100 Pa. Curve 13 in Fig. 4 shows the intensity of radiation at the focal spot 10 in the arrangement such as that shown in Fig. 1. The curve 14 in Fig. 4 shows the intensity of radiation at the focal spot 210 in an apparatus such as that shown in Fig. 2.

Similar results to those in Figure 3 are also observed in Figure 4, which shows the intensities of radiation from the focal spot 10 at a pressure of 100 Pa. When the discharge power is below about 300 W, the intensities of curves 13 and 14 are similar since only diffusion plasma of low radiation expands to the focal spot 10 and 210. Namely, at a pressure of 100 Pa, the plasma at powers below about 300 W is in the E-mode. At powers more than about 500 W, the difference between the intensities is about an order of magnitude. In the case of the standard configuration (curve 13) the radiation intensity remains almost independent from the discharge power in the range of powers between about 500 and 1000 W. In the case of the innovative configuration (curve 14) the radiation intensity increases with increasing power in the range of powers between about 500 and 1000 W.

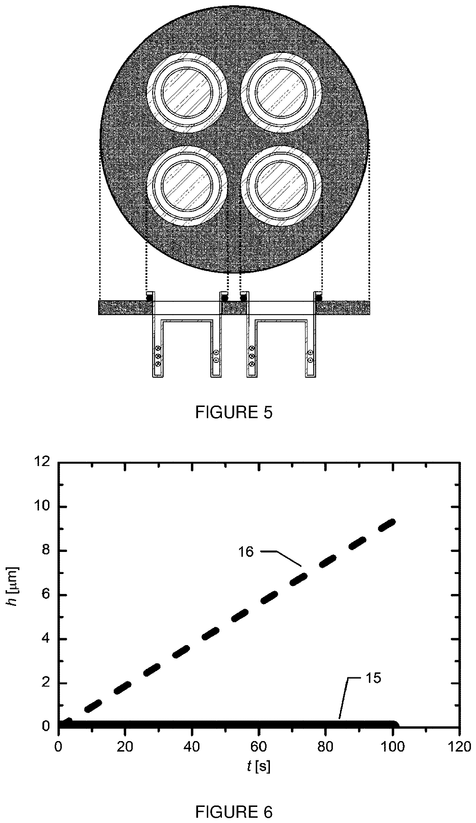

An apparatus for sustaining plasma in the H-mode may have plural double-cup shaped housings. Fig. 5 shows a second example embodiment of the invention. Herein, the apparatus comprises four plasma sources of the typed described, each having a coil. At least two coils may be connected in parallel to one RF generator.

Plasma sustained in the H-mode in an embodiment of the invention may be used in deposited film using the plasma-enhanced chemical vapour deposition of carbon nanomaterials from gaseous precursors. Figure 6 shows graphically the thickness of the deposited film versus treatment time using plasma sustained in the arrangement of Fig. 1 and plasma sustained according to the present invention.

Curve 15 represents the thickness of the deposited film in the arrangement such as that shown in Fig. 1. The curve 16 represents the thickness of the deposited film in an apparatus such as that shown in Fig. 2. Curve 16 is roughly 3 orders of magnitude greater than curve 15. The difference is explained by the fact that the dense plasma interacts with the substrate in the case represented by curve 16, and only diffusing plasma interacts with the substrate for the case of curve 15.

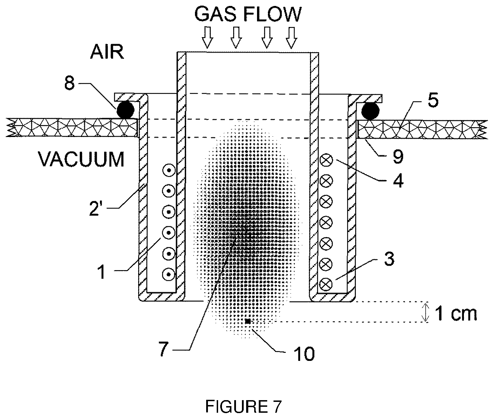

Fig. 7 shows schematically an apparatus for sustaining gaseous plasma in the H-mode in a third embodiment of the invention. The apparatus shown in Fig. 7 is similar to that shown in Fig. 2, and therefore replicated features will not be repeated in the structural discussion below. A high-frequency discharge may be used in an apparatus for sustaining gaseous plasma to facilitate the radicalisation of gaseous molecules, for example by dissociation due to electron impact. A gas may be arranged to drift through the centre of the generally tubular plasma tube 2', and to enter the vacuum chamber which is pumped continuously. The gas flow may be determined by the pumping speed of the pump used for evacuation of the metallic chamber. The average velocity of gas drifting through the dielectric tube is the ratio between the pumping speed of the pump used for evacuation of the metallic chamber and the cross-section of the plasma chamber 2'. The higher the drift velocity, the larger the supply of plasma into the vacuum chamber.

While the present invention has been shown and described with reference to examples given in the description and figures, these examples and embodiments as considered as illustrative and not restrictive. Moreover, the present invention is not to be limited to the details given herein, it will be understood by those skilled in the art that various changes in forms and details may be made without departure from the scope of the present invention.

## Claims

1. An apparatus for ignition and/or sustenance of an inductively coupled plasma, comprising:
a vacuum chamber (5) defined by a vacuum chamber wall (25) suitable for enclosing a plasma, said chamber wall having an opening therein;
a plasma chamber (2) located in the opening,
the plasma chamber (2) comprising a generally tubular dielectric side wall (22), a dielectric outer wall (211) substantially coaxial with the side wall (22), and at least an open end, the side wall (22) and outer wall (211) being continuous, such that the side wall (22) and outer wall (211) define a toroidal trough (21) in the vacuum chamber (5), the open end allowing fluid communication between the plasma chamber (2) and the vacuum chamber (5), the plasma chamber (2) being at least partially within the vacuum chamber wall (25); and
a radiofrequency coil (23) disposed around the periphery of the side wall (22) within the toroidal trough (21);
**characterized in that** a peripheral portion of the toroidal trough (21) comprising at least part of the side wall (22) and outer wall (211) is unshielded from the plasma.

2. An apparatus according to claim 1 wherein the plasma chamber (2) is substantially within the vacuum chamber wall (25).

3. An apparatus according to claim 1 or 2, wherein:
the vacuum chamber (5) comprises a metallic housing (29), wherein the distance between any point of the metallic housing (29) and an end of the radiofrequency coil (23) which is suitable for being coupled to an electric field generator is between 1 cm and 20 cm, preferably between 8 cm and 12 cm.

4. An apparatus according to any preceding claim wherein at least one of the side wall (22) and the outer wall (211) is hermetically sealed to the vacuum chamber wall (25).

5. An apparatus according to any preceding claim wherein the radiofrequency coil (23) consists of a single loop.

6. An apparatus according to any preceding claim comprising a plurality of openings formed in the chamber wall, and a plurality of plasma chambers (2) as defined in claim 1, said plurality of plasma chambers (2) being located in said plurality of openings, respectively.

7. An apparatus according to any preceding claim further comprising a radio frequency electric field generator (6).

8. An apparatus according to claim 7, wherein the radio frequency electric field generator (6) is arranged to supply the radiofrequency coil (23) with an electrical field having a frequency between 10 kHz and 1000 MHz.

9. Use of an apparatus as defined in any one of claims 1 to 8 for generating and/or sustaining inductively coupled gaseous plasma in the H-mode.

10. A method of treating the surface of a material comprising exposing the material to a plasma generated in an apparatus as claimed in any one of claims 1 to 8.

11. A method according to claim 10 wherein the radiofrequency coil (23) is surrounded by gas, preferably air, at a pressure high enough to prevent discharging.

12. A method according to claim 10 wherein the vacuum chamber (5) is at a pressure between 0.1 and 1000 Pa, preferably between 10 Pa and 100 Pa.

13. A method of igniting and/or sustaining an inductively coupled plasma, comprising:
providing a plasma chamber (2) in an opening of a vacuum chamber (5), the plasma chamber (2) being substantially within the vacuum chamber wall (25), wherein:
the plasma chamber (2) comprises a generally tubular dielectric side wall (22), a dielectric outer wall (211) substantially coaxial with the side wall (22), and at least an open end, the side wall (22) and outer wall (211) being continuous, such that the side wall (22) and outer wall (211) define a toroidal trough (21) in the vacuum chamber (5), the open end allowing fluid communication between the plasma chamber (2) and the vacuum chamber (5), and
a peripheral portion of toroidal trough (21) comprising at least part of the side wall (22) and outer wall (211) is unshielded from the plasma, and disposing a radiofrequency coil (23) around the periphery of the side wall (22) within the toroidal trough (21).

## Patentansprüche

1. Vorrichtung zum Zünden und/oder Aufrechterhalten eines induktiv gekoppelten Plasmas, umfassend:
eine Vakuumkammer (5), die durch eine Vakuumkammerwand (25) definiert ist, die zum Umschließen eines Plasmas geeignet ist, wobei die Kammerwand eine Öffnung darin aufweist;
eine sich in der Öffnung befindende Plasmakammer (2),
wobei die Plasmakammer (2) eine im Allgemeinen rohrförmige dielektrische Seitenwand (22), eine dielektrische Außenwand (211), die im Wesentlichen koaxial zu der Seitenwand (22) ist, und mindestens ein offenes Ende umfasst, wobei die Seitenwand (22) und die Außenwand (211) durchgehend sind, so dass die Seitenwand (22) und die Außenwand (211) einen torusförmigen Trog (21) in der Vakuumkammer (5) definieren, wobei das offene Ende eine Fluidverbindung zwischen der Plasmakammer (2) und der Vakuumkammer (5) ermöglicht, wobei sich die Plasmakammer (2) zumindest teilweise innerhalb der Vakuumkammerwand (25) befindet; und
eine Hochfrequenzspule (23), die um den Umfang der Seitenwand (22) innerhalb der torusförmigen Trogs (21) angeordnet ist;
**dadurch gekennzeichnet, dass** ein Umfangsabschnitt des torusförmigen Trogs (21) zumindest einen Teil der Seitenwand (22) umfasst und die Außenwand (211) nicht von dem Plasma abgeschirmt ist.

2. Vorrichtung nach Anspruch 1, wobei sich die Plasmakammer (2) im Wesentlichen innerhalb der Vakuumkammerwand (25) befindet.

3. Vorrichtung nach Anspruch 1 oder 2, wobei:
die Vakuumkammer (5) ein metallisches Gehäuse (29) umfasst, wobei der Abstand zwischen einem beliebigen Punkt des metallischen Gehäuses (29) und einem Ende der Hochfrequenzspule (23), die dazu geeignet ist, mit einem Kraftfelderzeuger gekoppelt zu werden, zwischen 1 cm und 20 cm, vorzugsweise zwischen 8 cm und 12 cm beträgt.

4. Vorrichtung nach einem der vorhergehenden Ansprüche, wobei mindestens eine von der Seitenwand (22) und der Außenwand (211) hermetisch an der Vakuumkammerwand (25) abgedichtet ist.

5. Vorrichtung nach einem der vorhergehenden Ansprüche, wobei die Hochfrequenzspule (23) aus einer einzigen Schleife besteht.

6. Vorrichtung nach einem der vorhergehenden Ansprüche, umfassend eine Vielzahl von Öffnungen, die in der Kammerwand ausgebildet sind, und eine Vielzahl von Plasmakammern (2), wie in Anspruch 1 definiert, wobei die Vielzahl von Plasmakammern (2) jeweils in der Vielzahl von Öffnungen angeordnet ist.

7. Vorrichtung nach einem der vorhergehenden Ansprüche, die ferner einen Kraftfeld-Hochfrequenzerzeuger (6) umfasst.

8. Vorrichtung nach Anspruch 7, wobei der Kraftfeld-Hochfrequenzerzeuger (6) angeordnet ist, um die Hochfrequenzspule (23) mit einem elektrischen Feld mit einer Frequenz zwischen 10 kHz und 1000 MHz zu versorgen.

9. Verwendung einer Vorrichtung nach einem der Ansprüche 1 bis 8 zur Erzeugung und/oder Aufrechterhaltung eines induktiv gekoppelten gasförmigen Plasmas im H-Modus.

10. Verfahren zur Behandlung der Oberfläche eines Materials, bei dem das Material einem Plasma ausgesetzt wird, das in einer Vorrichtung nach einem der Ansprüche 1 bis 8 erzeugt wird.

11. Verfahren nach Anspruch 10, wobei die Hochfrequenzspule (23) von einem Gas, vorzugsweise Luft umgeben ist, mit einem Druck, der hoch genug ist, um ein Entladen zu verhindern.

12. Verfahren nach Anspruch 10, wobei der Druck in der Vakuumkammer (5) zwischen 0,1 und 1000 Pa, vorzugsweise zwischen 10 Pa und 100 Pa, liegt.

13. Verfahren zum Zünden und/oder Aufrechterhalten eines induktiv gekoppelten Plasmas, umfassend:
Bereitstellen einer Plasmakammer (2) in einer Öffnung einer Vakuumkammer (5), wobei sich die Plasmakammer (2) im Wesentlichen innerhalb der Vakuumkammerwand (25) befindet, wobei:
die Plasmakammer (2) eine im Allgemeinen rohrförmige dielektrische Seitenwand (22), eine dielektrische Außenwand (211), die im Wesentlichen koaxial zu der Seitenwand (22) ist, und mindestens ein offenes Ende umfasst, wobei die Seitenwand (22) und die Außenwand (211) durchgehend sind, so dass die Seitenwand (22) und die Außenwand (211) einen torusförmigen Trog (21) in der Vakuumkammer (5) definieren, wobei das offene Ende eine Fluidverbindung zwischen der Plasmakammer (2) und der Vakuumkammer (5) ermöglicht, und
ein Umfangsabschnitt des torusförmigen Trogs (21) zumindest einen Teil der Seitenwand (22) umfasst und die Außenwand (211) nicht von dem Plasma abgeschirmt ist, und
Anordnen einer Hochfrequenzspule (23) um den Umfang der Seitenwand (22) innerhalb des torusförmigen Trogs (21).

## Revendications

1. Dispositif d'allumage et/ou de maintien d'un plasma à couplage inductif, comprenant :
une chambre à vide (5) définie par une paroi de la chambre à vide (25) appropriée pour renfermer un plasma, ladite paroi de la chambre étant dotée d'une ouverture à l'intérieur de celle-ci ;
une chambre à plasma (2) située dans l'ouverture,
la chambre à plasma (2) comprenant une paroi latérale diélectrique généralement tubulaire (22), une paroi externe diélectrique (211) sensiblement coaxiale avec la paroi latérale (22), et au moins une extrémité ouverte, la paroi latérale (22) et la paroi externe (211) étant continues, de telle sorte que la paroi latérale (22) et la paroi externe (211) définissent une cuve toroïdale (21) dans la chambre à vide (5), l'extrémité ouverte permettant une communication fluidique entre la chambre à plasma (2) et la chambre à vide (5), la chambre à plasma (2) étant au moins partiellement à l'intérieur de la paroi de la chambre à vide (25) ; et
une bobine radiofréquence (23) disposée autour de la périphérie de la paroi latérale (22) à l'intérieur de la cuve toroïdale (21) ;
**caractérisé en ce qu'**une partie périphérique de la cuve toroïdale (21) comprend au moins une partie de la paroi latérale (22) et la paroi externe (211) est non protégée du plasma.

2. Dispositif selon la revendication 1, dans lequel la chambre à plasma (2) est sensiblement à l'intérieur de la paroi de la chambre à vide (25).

3. Dispositif selon la revendication 1 ou 2, dans lequel :
la chambre à vide (5) comprend un boîtier métallique (29), la distance entre n'importe quel point du boîtier métallique (29) et une extrémité de la bobine radiofréquence (23) qui est appropriée pour être couplée à un générateur de champ électrique étant comprise entre 1 cm et 20 cm, de préférence entre 8 cm et 12 cm.

4. Dispositif selon l'une quelconque des revendications précédentes, dans lequel au moins l'une de la paroi latérale (22) et de la paroi externe (211) est hermétiquement scellée à la paroi de la chambre à vide (25).

5. Dispositif selon l'une quelconque des revendications précédentes, dans lequel la bobine radiofréquence (23) est constituée d'une seule boucle.

6. Dispositif selon l'une quelconque des revendications précédentes, comprenant une pluralité d'ouvertures formées dans la paroi de la chambre et une pluralité de chambres à plasma (2) comme définies dans la revendication 1, ladite pluralité de chambres à plasma (2) étant située dans ladite pluralité d'ouvertures, respectivement.

7. Dispositif selon l'une quelconque des revendications précédentes, comprenant en outre un générateur de champ électrique radiofréquence (6).

8. Dispositif selon la revendication 7, dans lequel le générateur de champ électrique radiofréquence (6) est agencé pour alimenter la bobine radiofréquence (23) avec un champ électrique ayant une fréquence comprise entre 10 kHz et 1000 MHz.

9. Utilisation d'un dispositif tel que défini dans l'une quelconque des revendications 1 à 8 pour générer et/ou entretenir un plasma gazeux à couplage inductif dans le mode H.

10. Procédé de traitement de la surface d'un matériau consistant à exposer le matériau à un plasma généré dans un dispositif selon l'une quelconque des revendications 1 à 8.

11. Procédé selon la revendication 10, dans lequel la bobine radiofréquence (23) est entourée par un gaz, de préférence de l'air, à une pression suffisamment élevée pour empêcher la décharge.

12. Procédé selon la revendication 10, dans lequel la chambre à vide (5) est à une pression comprise entre 0,1 et 1000 Pa, de préférence entre 10 Pa et 100 Pa.

13. Procédé d'allumage et/ou de maintien d'un plasma à couplage inductif, comprenant :
la fourniture d'une chambre à plasma (2) dans une ouverture d'une chambre à vide (5), la chambre à plasma (2) étant sensiblement à l'intérieur de la paroi de la chambre à vide (25) :
la chambre à plasma (2) comprenant une paroi latérale diélectrique généralement tubulaire (22), une paroi externe diélectrique (211) sensiblement coaxiale avec la paroi latérale (22), et au moins une extrémité ouverte, la paroi latérale (22) et la paroi externe (211) étant continues, de telle sorte que la paroi latérale (22) et la paroi externe (211) définissent une cuve toroïdale (21) dans la chambre à vide (5), l'extrémité ouverte permettant une communication fluidique entre la chambre à plasma (2) et la chambre à vide (5), et
une partie périphérique de la cuve toroïdale (21) comprenant au moins une partie de la paroi latérale (22) et la paroi externe (211) n'est pas protégée du plasma, et
la disposition d'une bobine radiofréquence (23) autour de la périphérie de la paroi latérale (22) à l'intérieur de la cuve toroïdale (21).
